# EUROPÄISCHE PATENTSCHRIFT

(11) **EP 2 561 739 B1**
(45) Veröffentlichungstag und Bekanntmachung des Hinweises auf die Patenterteilung: **16.09.2015**
(21) Anmeldenummer: 11709916.8
(22) Anmeldetag: 15.03.2011
(51) Int. Cl.: H05K 7/20, H05K 5/02, F04D 29/64, F04D 29/70

(54) **LUFTFÜHRUNGSANORDNUNG**
AIR GUIDANCE SYSTEM
SYSTÈME DE GUIDAGE D'AIR

(30) Priorität: 19.04.2010 DE 102010016507
(43) Veröffentlichungstag der Anmeldung: 27.02.2013
(73) Patentinhaber: RITTAL GmbH & Co. KG, 35745 Herborn (DE)
(72) Erfinder: HARTMANN, Reiner, 35435 Wettenberg (DE); SCHNEIDER, Stefan, 35080 Bad Endbach (DE); RONZHEIMER, Claudia Christine, 35232 Dautphetal (DE)
(74) Vertreter: Angerhausen, Christoph
(86) Internationale Anmeldenummer: PCT/EP2011/053900
(87) Internationale Veröffentlichungsnummer: WO 2011/131426

(56) Entgegenhaltungen:
- DE-A1- 3 532 169
- DE-U1- 20 006 849
- US-A1- 2003 193 774
- US-A1- 2007 056 229
- US-B1- 6 583 991

## Beschreibung

Die Erfindung betrifft eine Luftführungsanordnung mit einem Luftführungsgehäuse und einem daran befestigten Luft-Durchtrittsgitter, wobei das Luft-Durchtrittsgitter mittels einer Rastverbindung an dem Luftführungsgehäuse gehalten ist, wobei das Luftführungsgehäuse wenigstens einen Riegel mit einem Rastansatz trägt, der in eine Rastaufnahme des Luft-Durchtrittsgitters einrastbar ist, und wobei das Luft-Durchtrittsgitter in einer Lageraufnahme einen Griff schwenkbar aufnimmt, der bei seiner Verstellung von der Arretierstellung in die Entriegelstellung den Riegel außer Eingriff mit der Rastaufnahme bringt. Eine gattungsgemäße Luftführungsanordnung ist aus der US 2007/056229 A1 bekannt. Ähnliche Anordnungen beschreiben auch die DE 35 32 169 A1, die US 6,583,991 B1, die US 2003/193774 A1 und die DE 200 06 849 U1.

Solche Luftführungsanordnungen werden im Schaltschrankbau verwendet und lassen sich in einen Ausschnitt einer Schaltschrankwand einsetzen. Häufig sind mit den Luftführungsanordnungen Ventilatorbaugruppen kombiniert, die Umgebungsluft durch das Luft-Durchtrittsgitter ansaugen, und über das Luftführungsgehäuse in den Schaltschrankinnenraum abgeben.

Im Luftführungsgehäuse ist regelmäßig eine Filtermatte gehalten, die Partikel aus der angesaugten Luft ausfiltert. Diese Filtermatte muss in regelmäßigen Intervallen ausgetauscht werden. Hierzu wird das Luft-Durchtrittsgitter vom Luftführungsgehäuse demontiert. Das Luft-Durchtrittsgitter ist mittels einer Rastverbindung an dem Luftführungsgehäuse gehalten. Dabei ist die Rastverbindung so ausgelegt, dass sie nur mit einem Schraubenzieher entriegelt werden kann.

Es ist Aufgabe der Erfindung, eine Luftführungsanordnung der eingangs erwähnten Art zu schaffen, bei der das Wartungspersonal auf einfache Weise Zugang zum Innenraum des Luftführungsgehäuses erhält.

Diese Aufgabe wird dadurch gelöst, dass der Griff zwei Lageransätze trägt, die eine gemeinsame Lagerachse bilden, und die jeweils in eine Lageraufnahme eingerastet sind. Die gemeinsame Lagerachse bildet eine stabile Ankopplung des Griffes an das Luft-Durchtrittsgitter. Dadurch, dass der Griff im Luft-Durchtrittsgitter eingerastet ist, lässt er sich einfach mit diesem zugunsten eines verringerten Montageaufwandes verbinden.

Bei der Wartung muss zum Austausch der Filtermatte somit kein separates Werkzeug bereitgehalten werden, sondern es muss lediglich der Griff verschwenkt werden, um die Rastverbindung aufzuheben. Auf diese Weise wird eine zeitsparende Wartung auch bei beengten Platzverhältnissen möglich.

Eine zuverlässige Aufhebung der Rastverbindung gelingt dann auf einfache Weise, wenn vorgesehen ist, dass der Griff wenigstens ein Stellglied aufweist, das eine Auflaufschräge bildet, die zur Entriegelung des Rastansatzes mit einer Schrägfläche des Rastansatzes derart zusammenwirkt, dass der Rastansatz ausgelenkt wird. Beim Verschwenken des Griffes gleitet die Auflaufschräge an der Schrägfläche auf. Hierdurch wird eine Kraftuntersetzung erreicht, mit der auch stabile und schwergängige Rastverbindungen einfach aufgehoben werden können.

Eine besonders stabile Ankopplung des Luft-Durchtrittsgitters kann dadurch erhalten werden, dass am Luftführungsgehäuse zwei Riegel angeordnet sind, die bei einer Betätigung des Griffes mittels jeweils eines zugeordneten Stellgliedes entriegelbar sind.

Eine besonders bevorzugte Luftführungsanordnung ist der Gestalt, dass der Griff ein Abdrückstück aufweist, das beabstandet von der Schwenkachse des Griffes angeordnet ist, und dass das Abdrückstück zum Abdrücken des Luft-Durchtrittsgitters aus der Verriegelungsstellung an eine Abdrückfläche des Luftführungsgehäuses andrückbar ist.

Bei einer Bedienung des Griffes wird damit zum Einen die Rastverbindung zwischen dem Luft-Durchtrittsgitter und dem Luftführungsgehäuse aufgehoben. Zum Anderen schiebt der Griff mit dem Abdrückstück das entriegelte Luft-Durchtrittsgitter ein Stück weit von dem Luftführungsgehäuse ab, sodass es bequem gegriffen und weiter geöffnet werden kann.

Wenn vorgesehen ist, dass der Griff einen Anschlag aufweist, der in der Entriegelungsstellung des Griffes an einem Arretierstück des Luft-Durchtrittsgitters anschlägt, dann wird der Griff auch dann noch sicher am Luft-Durchtrittsgitter gehalten, wenn eine Bedienperson unzulässig stark an dem Griff zieht.

Eine besonders zeitsparende Wartung der Luftführungsanordnung wird dann möglich, wenn vorgesehen ist, dass das Luft-Durchtrittsgitter mittels einer Scharnierverbindung schwenkbar an dem Luftführungsgehäuse angekoppelt ist. Dann kann zunächst mit dem Griff die Rastverbindung aufgehoben werden. Anschließend lässt sich das Luft-Durchtrittsgitter in der Scharnierverbindung abklappen, sodass der Innenraum des Luftführungsgehäuses zugänglich wird. Das Luft-Durchtrittsgitter muss nun, da es noch in der Scharnierverbindung gehalten ist, nicht beiseite gelegt werden. Das Bedienpersonal kann nun die Filtermatte wechseln und anschließend das Luft-Durchtrittsgitter in der Scharnierverbindung wieder verklappen, bis es seine Montagestellung erreicht. Dabei verrastet dann das Luft-Durchtrittsgitter wieder im Bereich des Griffes und es ist somit sicher festgelegt.

Die Erfindung wird im Folgenden anhand eines in den Zeichnungen dargestellten Ausführungsbeispieles näher erläutert. Es zeigen:
- Figur 1: in perspektivischer Frontansicht ein Luft-Durchtrittsgitter;
- Figur 2: die Darstellung gemäß Figur 1, jedoch in einer veränderten Montageform;
- Figuren 3 bis 6: einen Griff in verschiedenen Ansichten; und
- Figur 7: ein Luftführungsgehäuse in perspektivischer Frontansicht.

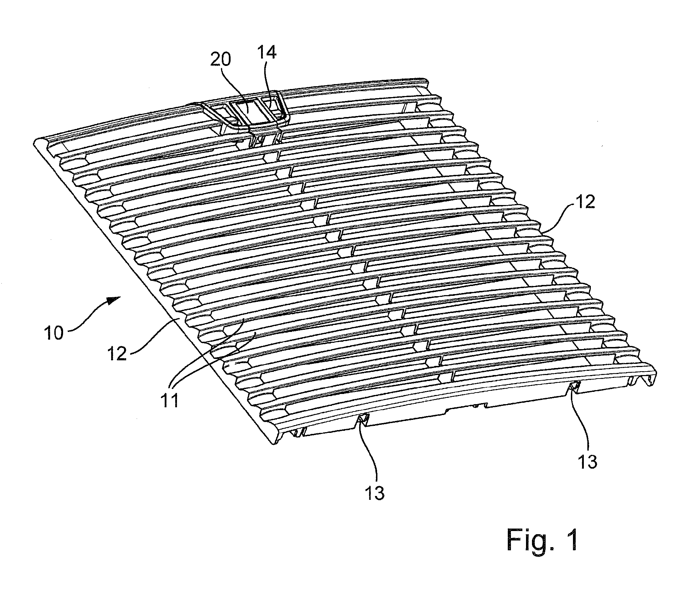

Figur 1 zeigt ein Luft-Durchtrittsgitter 10 mit einer Vielzahl von zueinander parallelen Lamellen 11. Die Lamellen 11 sind an ihren längsseitigen Enden mittels Stegen 12 einteilig aneinander geschlossen. Im Bereich des unteren horizontalen Randes weist das Luft-Durchtrittsgitter 10 zwei Scharnieraufnahmen 13 auf, die zur Bildung einer horizontalen Scharnierachse ausgelegt sind. Am oberen horizontalen Rand ist das Luft-Durchtrittsgitter 10 mit einer Verschlussaufnahme 14 ausgestattet. In dieser Verschlussaufnahme 14 ist ein Griff 20 festgelegt.

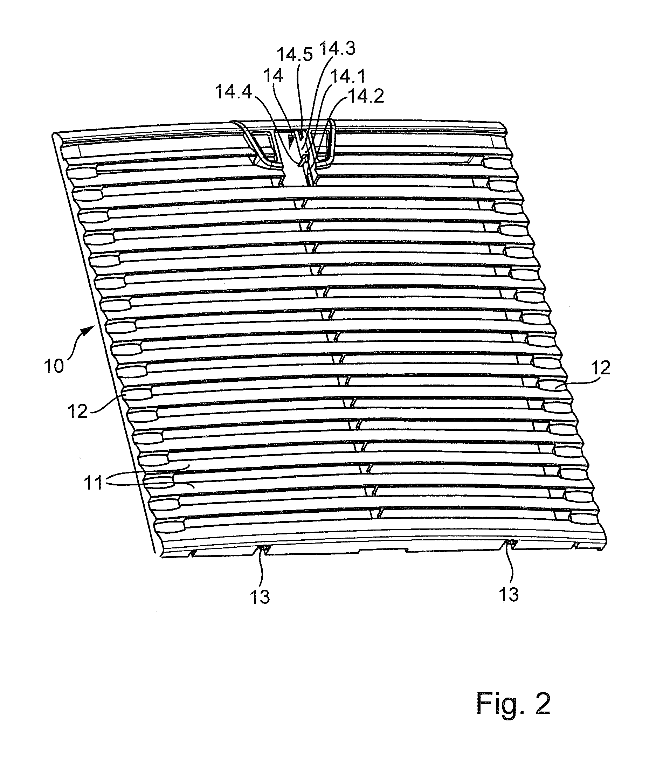

Figur 2 zeigt das Luft-Durchtrittsgitter 10 gemäß Figur 1, jedoch mit demontiertem Griff 20. Wie diese Darstellung erkennen lässt, ist das Luft-Durchtrittsgitter 10 im Bereich der Verschlussaufnahme 14 mit einem Durchbruch versehen. Dabei ist der Durchbruch seitlich von zwei parallelen Führungswänden 14.3 begrenzt. In die Führungswände 14.3 sind Ausnehmungen ausgearbeitet, die eine Lageraufnahme 14.1 bilden. Die Lageraufnahmen 14.1 weisen einen Einführabschnitt auf, in dem ein Rastelement 14.4 integriert ist. Weiterhin weist jede Führungswand 14.3 eine Rastaufnahme 14.5 auf. An der Unterseite jeder Lageraufnahme 14.1 ist jeweils ein Arretierstück 14.2 in Form eines Steges angeformt, wobei die Arretierstücke 14.2 einander zugewandt sind.

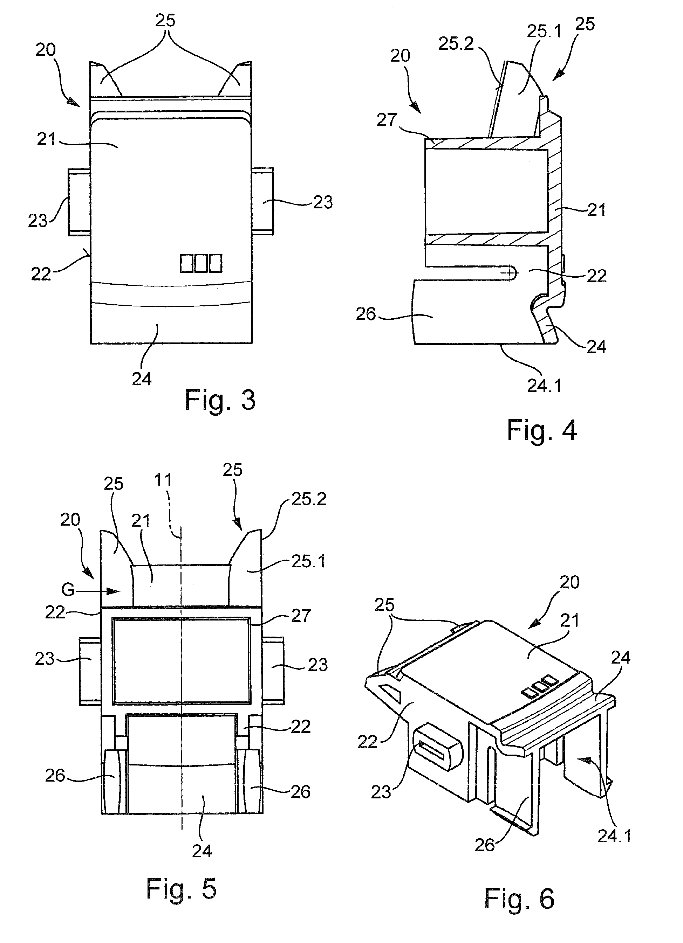

In der Verschlussaufnahme 14 lässt sich der in den Figuren 3 bis 6 detaillierte Griff 20 montieren. Wie diese Darstellungen zeigen, ist der Griff 20 einteilig als Spritzgussteil ausgeführt. Er weist eine plattenförmige Frontabdeckung 21 auf, an die zwei zueinander parallele Seitenwände 22 rechtwinklig angeformt sind. Die Seitenwände 22 bilden zusammen mit Wandabschnitten 27 eine Aufnahme, in der elektrische Komponenten hinter der Frontabdeckung 21 befestigt werden können. Beispielsweise kann eine Batterie oder eine Schaltvorrichtung einer Anzeigeeinheit hier integriert sein.

Von der Seitenwand 22 sind zwei lappenförmige Ansätze freigestellt, die Anschläge 26 bilden. Die beiden Anschläge 26 sind über einen Griffabschnitt 24 miteinander verbunden. Im Bereich zwischen dem Griffabschnitt 24 und den beiden Anschlägen 26 ist eine Griffmulde 24.1 gebildet.

Auf der dem Griffabschnitt 24 abgewandeten Seite weist der Griff 20 zwei zueinander beabstandet angeordnete Stellglieder 25 auf. Diese Stellglieder 25 sind in Form von Vorsprüngen ausgebildet und weisen jeweils eine geneigt verlaufende Auflaufschräge 25.1 auf. Diese Auflaufschräge 25.1 verläuft geneigt zu der Mittelquerebene M des Griffes 20 (siehe Figur 5). Dabei fällt die Auflaufschräge 25.1 ausgehend von der durch die Seitenwand 22 festgelegte Ebene in Richtung zur Frontabdeckung 21 hin ab, wie dies die Figur 5 zeigt. Zur besseren Verdeutlichung ist in Figur 5 an dem linksseitigen Stellglied 25 die Gefällerichtung D, mit der die Auflaufschräge 25.1 abfällt, gekennzeichnet. Jedes Stellglied 25 bildet in der Verlängerung der Seitenwand 22 ein Abdrückstück 25.2 in Form einer Abdrückschulter.

In der Verschlussaufnahme 14 kann das Luft-Durchtrittsgitter 10 montiert werden. Hierzu wird der Griff 20 von der Rückseite des Luft-Durchtrittsgitters 10 her mit der Frontabdeckung 21 voran in die Verschlussaufnahme 14 eingeschoben. Dabei gleiten die Seitenwände 22 an den Führungswänden 14.3 entlang. Beim Einschieben des Griffes 20 gelangen die Lageransätze 23 in den Bereich der Rastelemente 14.4. Die Rastelemente 14.4 werden dabei in entgegengesetzte Richtungen ausgelenkt. Wenn die Lageransätze 23 die Rastelemente 14.4 passiert haben und in die Lageraufnahmen 14.1 gelangen, hinterschnappen die Rastelemente 14.4 die Lageransätze 23, sodass der Griff 20 sicher am Luft-Durchtrittsgitter 10 gehalten ist. Dann bilden die Lageransätze 23 in den Lageraufnahmen 14.1 eine horizontale Schwenkachse, um die der Griff 20 geschwenkt wird. Der Griff 20 kann dabei, ausgehend aus der in Figur 1 gezeigten Arretierstellung, in eine Entriegelungsstellung verschwenkt werden. Hierzu bietet die Griffmulde 24.1 eine Aufnahme für den Finger, mit dem der Griffabschnitt 24 hintergriffen werden kann. Nun kann der Griff 20 am Griffabschnitt 24 um die Schwenkachse geklappt werden. Die Schwenkbewegung wird dabei mit den Anschlägen 26 begrenzt, wobei die Ansätze 26 an den Arretierstücken in der ausgeschwenkten Arretierstellung anschlagen.

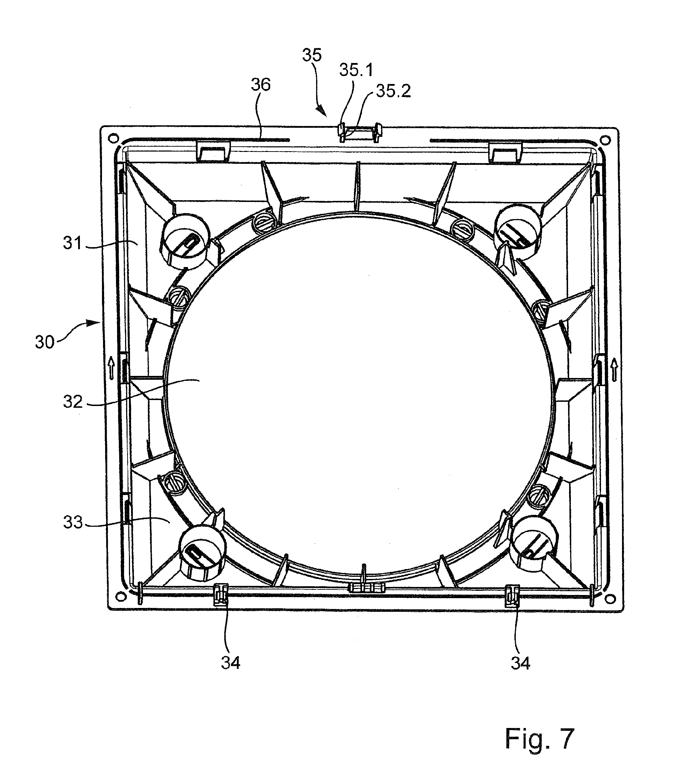

Die aus Luft-Durchtrittsgitter 10 und Griff 20 gebildete Baueinheit kann mit dem Luftführungsgehäuse gemäß Figur 7 verbunden werden. Das Luftführungsgehäuse 30 weist eine umlaufende Gehäusewand 31 auf, die mit einem Boden 33 abgeschlossen ist. Der Boden 33 ist von einer Luftdurchtrittsöffnung 32 durchdrungen. Die Gehäusewand 31 ist mit einem nach außen abstehenden, umlaufenden Bund 36 versehen. Im Bereich des oberen horizontalen Randes des Luftführungsgehäuses 30 ist eine Riegelanordnung mit zwei Riegeln 35 einteilig angeformt. Dabei sind die Riegel 35 sind mit Federelementen 35.2, die als an den Bund 36 angeformte Lappen ausgebildet sind, ausgestattet. Die Federelemente 35.2 tragen an ihren freien Enden Rastansätze 35.1. Am unteren horizontalen Rand des Luftführungsgehäuses 30 sind zwei Scharnierelemente 34 angeformt.

Zur Verbindung des Luft-Durchtrittsgitters 10 mit dem Luftführungsgehäuse 30 werden die Scharnieraufnahmen 13 des Luft-Durchtrittsgitters 10 mit den Scharnierelementen 34 verrastet. Dabei wird dann eine Scharnierverbindung mit einer horizontalen Schwenkachse gebildet, um die das Luft-Durchtrittsgitter 10 verschwenkt werden kann. Dabei kann das Luft-Durchtrittsgitter 10 ausgehend von einer geöffneten Wartungsstellung, in der der Innenraum des Luftführungsgehäuses 30 zugänglich ist, in eine hochgeklappte Montagestellung gebracht werden. Beim Hochklappen des Luft-Durchtrittsgitters 10 gelangen die Riegel 35 in den Bereich der Verschlussaufnahme 14 und rasten in die Rastaufnahmen 14.5 ein. Damit ist das Luft-Durchtrittsgitter 10 sicher festgelegt. Wenn es nun wieder geöffnet werden soll, so muss lediglich der Griff 20 am Griffabschnitt 24 gegriffen und ausgeschwenkt werden. Dabei gleiten die Auflaufschrägen 25.1 des Griffes 20 auf den geneigten Rastflächen der Rastansätze 35.1 auf. Dann werden die Riegel 35 in den Federelementen 35.2 ausgelenkt und aufeinander zu bewegt. Sie kommen dann außer Eingriff mit den Rastaufnahmen 14.5. Wird die Schwenkbewegung des Griffes 20 weitergeführt, so trifft das Abdrückstück 25.2 der Stellglieder 25 frontseitig auf den Bund 36 des Luftführungsgehäuses 30. Dadurch lässt sich das Luft-Durchtrittsgitter 10 ein Stück weit vom Luftführungsgehäuse 30 abschieben. Es entsteht ein Spalt, an dem das Luft-Durchtrittsgitter 10 gegriffen und aufgeschwenkt werden kann.

## Patentansprüche

1. Luftführungsanordnung mit einem Luftführungsgehäuse (30) und einem daran befestigten Luft-Durchtrittsgitter (10), wobei das Luft-Durchtrittsgitter (10) mittels einer Rastverbindung an dem Luftführungsgehäuse (30) gehalten ist, wobei das Luftführungsgehäuse (30) wenigstens einen Riegel (35) mit einem Rastansatz (35.1) trägt, der in eine Rastaufnahme (14.5) des Luft-Durchtrittsgitters (10) einrastbar ist, und wobei das Luft-Durchtrittsgitter (10) in einer Lageraufnahme (14.1) einen Griff (20) schwenkbar aufnimmt, der bei seiner Verstellung von der Arretierstellung in die Entriegelstellung den Riegel (35) außer Eingriff mit der Rastaufnahme (14.5) bringt,
**dadurch gekennzeichnet,**
**dass** der Griff (20) zwei Lageransätze (23) trägt, die eine gemeinsame Lagerachse bilden und die jeweils in eine Lageraufnahme (14.1) eingerastet sind.

2. Luftführungsanordnung nach Anspruch 1,
**dadurch gekennzeichnet,**
**dass** der Griff (20) ein Abdrückstück (25.2) aufweist, das beabstandet von der Schwenkachse des Griffs (20) angeordnet ist, und
**dass** das Abdrückstück (25.2) zum Abdrücken des Luft-Durchtrittsgitters (10) aus der Verriegelungsstellung an eine Abdrückfläche des Luftführungsgehäuses (30) andrückbar ist.

3. Luftführungsanordnung nach einem der Ansprüche 1 oder 2,
**dadurch gekennzeichnet,**
**dass** der Griff (20) einen Anschlag (26) aufweist, der in der Entriegelungsstellung des Griffs (20) an einem Arretierstück (14.2) des Luft-Durchtrittsgitters (10) anschlägt.

4. Luftführungsanordnung nach einem der Ansprüche 1 bis 6,
**dadurch gekennzeichnet,**
**dass** das Luft-Durchtrittsgitter (10) mittels einer Scharnierverbindung schwenkbar an dem Luftführungsgehäuse (30) angekoppelt ist.

## Claims

1. An air guidance system having an air guidance housing (30) and an air passage grating (10) fastened thereto, the air passage grating (10) being held on the air guidance housing (30) by means of a snap-lock connection, wherein the air guidance housing (30) carries at least one latch (35) having a snap-in shoulder (35.1) that can be engaged in a snap-lock seat (14.5) of the air passage grating (10), and wherein the air passage grating (10) pivotally accommodates a handle (20) in a bearing seat (14.1), said handle disengaging the latch (35) from the snap-lock seat (14.5) when set from the locking position to the unlocking position,
**characterized in that**
the handle (20) carries two bearing tabs (23) forming a common bearing axis and which respectively are engaged in a bearing seat (14.1).

2. The air guidance system of claim 1, **characterized in that** the handle (20) has a press-off piece (25.2) spaced apart from the pivot axis of the handle (20), and that the press-off piece (25.2) can be pressed on a press-on face of the air guidance housing (30) for pressing off the air passage grating (10) from the locking position.

3. The air guidance system of any of claims 1 or 2, **characterized in that** the handle (20) comprises a stopper (26) abutting at a locking piece (14.2) of the air passage grating (10) in the unlocking position of the handle (20).

4. The air guidance system of any of claims 1 to 3, **characterized in that** the air passage grating (10) is pivotally coupled to the air guidance housing (30) by means of a hinge connection.

## Revendications

1. Dispositif de circulation d'air comprenant un logement de circulation d'air (30) et une grille de passage d'air (10), dans lequel la grille de passage d'air (10) est maintenue sur le logement de circulation d'air (30) au moyen d'une liaison par encliquetage, dans lequel le logement de circulation d'air (30) supporte au moins un verrou (35) ayant un taquet d'encliquetage (35.1) qui peut s'encliqueter dans un logement d'encliquetage (14.5) de la grille de passage d'air (10), et dans lequel la grille de passage d'air (10) reçoit de façon basculante, dans un logement de palier (14.1), une poignée (20) qui, lorsqu'elle est déplacée de la position d'arrêt à la position de déverrouillage, amène le verrou (35) hors de prise avec le logement d'encliquetage (14.5),
**caractérisé**
**en ce que** la poignée (20) supporte deux pièces rapportées de palier (23) qui forment un axe de palier commun et qui sont chacune encliquetées dans un logement de palier (14.1).

2. Dispositif de circulation d'air selon la revendication 1,
**caractérisé**
**en ce que** la poignée (20) présente une pièce de séparation (25.2) qui est agencée à distance de l'axe de basculement de la poignée (20), et
**en ce que** la pièce de séparation (25.2) peut être pressée sur une surface de séparation du logement de circulation d'air (30) pour faire sortir la grille de passage d'air (10) de la position de verrouillage.

3. Dispositif de circulation d'air selon l'une des revendications 1 ou 2,
**caractérisé**
**en ce que** la poignée (20) présente une butée (26) qui, dans la position de déverrouillage de la poignée (20), bute contre une pièce d'arrêt (14.2) de la grille de passage d'air (10).

4. Dispositif de circulation d'air selon l'une des revendications 1 à 6,
**caractérisé**
**en ce que** la grille de passage d'air (10) est couplée de façon basculante avec le logement de circulation d'air (30) au moyen d'une liaison à charnière.
